Europäisches Patentamt

European Patent Office

Office européen des brevets

(19)

(11) Veröffentlichungsnummer: **0 321 734**
**A1**

## (12) EUROPÄISCHE PATENTANMELDUNG

(21) Anmeldenummer: 88119769.3

(22) Anmeldetag: 26.11.88

(51) Int. Cl.4: **C23C 16/18 , C23C 16/16 , H05K 3/02**

(30) Priorität: 22.12.87 DE 3744062

(43) Veröffentlichungstag der Anmeldung:
28.06.89 Patentblatt 89/26

(84) Benannte Vertragsstaaten:
BE CH DE ES FR GB IT LI LU NL SE

(71) Anmelder: **SCHERING AKTIENGESELLSCHAFT Berlin und Bergkamen**
**Müllerstrasse 170/178 Postfach 65 03 11**
**D-1000 Berlin 65(DE)**

(72) Erfinder: **Suhr, Harald, Prof. Dr.rer.nat.**
**Weissdornweg 2**
**D-7400 Tübingen(DE)**
Erfinder: **Haag, Christa, Dr.**
**Kirchstrasse 9**
**D-7404 Ofterdingen(DE)**

(54) Verfahren zur Herstellung fest haftender metallischer Strukturen auf Fluor-polymeren und thermoplastischen Kunststoffen.

(57) Verfahren zur Herstellung metallischer Strukturen auf Nichtleitern durch Zersetzung metallorganischer Verbindungen in einer Glimmentladung unter Bildung eines metallischen Films, dadurch gekennzeichnet, daß als Nichtleiter Kunststoffe aus dem Bereich der Fluorpolymere oder der thermoplastischen Kunststoffe verwendet werden.

EP 0 321 734 A1

## VERFAHREN ZUR HERSTELLUNG FEST HAFTENDER METALLISCHER STRUKTUREN AUF FLUOR-POLYMEREN UND THERMOPLASTISCHEN KUNSTSTOFFEN

Die vorliegende Erfindung betrifft ein Verfahren zur Herstellung metallischer Strukturen auf Nichtleitern durch Zersetzung metallorganischer Verbindungen in einer Glimmentladung unter Bildung eines metallischen Films.

Die Herstellung metallischer Filme auf Kunststoffen erfolgt in konventioneller Weise normalerweise naßchemisch, dadurch, daß die zu metallisierenden Teile in eine speziell für ein Substrat formulierte Reihe von Reinigungs-, Ätz-, Konditionierungs-,Aktivierungs- und Metallisierungsbäder getaucht werden. Hierbei wird die Oberfläche nach der Reinigung und Konditionierung zunächst mit edelmetallhaltigen Lösungen bekeimt und danach auf den aktivierten Flächen nach herkömmlichen Verfahren metallisiert.

Die Behandlungsbäder sind in der Regel wässrige Lösungen, enthalten zum Teil jedoch auch organische Lösungsmittel. Nachteil dieser Formulierungen ist zum Teil hohe Toxizität bei erheblicher Flüchtigkeit der verwendeten Verbindungen, die entsprechende Sicherheitsvorkehrungen voraussetzt. Im Falle des Polytetrafluoroethylens ist wegen der hohen Hydrophobie des Materials nur eine rein organische Formulierung auf der Basis von Natrium-Carbanion-Komplexen als Ätzlösung bekannt, die eine ausreichende Haftung des abschließend aufzubringenden Metallfilms gewährleistet. Daher hat sich aus Gründen der Giftigkeit der Vorbehandlungschemie und aus Sicherheitsgründen Polytetrafluorethylen als Substrat in der Elektroindustrie noch nicht durchsetzen können, obwohl es in Bezug auf seine elektrischen und chemischen Kenndaten den meisten anderen Materialien weit überlegen ist. Problematisch ist auch die Entsorgung der toxischen Behandlungsbäder.

Ein weiterer wesentlicher Nachteil der naßchemischen Verfahren besteht darin, daß relativ komplizierte Vorbehandlungssequenzen vorzusehen sind, ehe metallisiert wird, um die gewunschten Haftungswerte zu erreichen. Dabei sind in jedem Falle die verfahrenstechnischen Parameter, wie zum Beispiel Temperatur und Behandlungszeit in engen Grenzen zu halten, so daß unter Umständen eine umfangreiche Prozeßkontrolle benötigt wird. Die Gefahr der Kontamination der Behandlungsbader durch prozeßbedingte Verfahrensschwankungen ist groß und kann deutliche Qualitatsschwankungen zur Folge haben. Die Aggresivität der Behandlungslosungen wirkt sich unter Umständen qualitätsmindernd auf Abdecklacke oder -folien aus.

Ein anderes Beschichtungsverfahren ist die thermische Zersetzung von flüchtigen Metallverbindungen. Dieses Verfahren setzt sehr hohe Substrattemperaturen (mind. 200° C, in der Praxis aber 300 - 1000° C) voraus, die aber im Falle der genannten Materialien nicht oder nur unter Gefahr der Materialschädigung erreicht werden dürfen.

Die vorliegende Erfindung hat zur Aufgabe, fest haftende metallische Strukturen auf Fluorpolymeren und thermoplastischen Kunststoffen herzustellen. Die so hergestellten Halbzeuge werden zum Beispiel in der Elektronikindustrie verwendet, insbesondere für die Herstellung von Leiterplatten, Hybridschaltungen, Chip Carrier dreidimensionaler Formkörper mit Leiterbahnstrukturen oder ganzflächig metallisierter dreidimensionaler Formkörper im Einsatz für die Abschirmung elektromagnetischer Felder. Die genannten Materialien, wie zum Beispiel Polytetrafluorethylen, Polyamide, Polyetherimide und -sulfone, Polyparaphenylensulfid, Polyester oder parakristalline Polymere unterscheiden sich von herkömmlichen Polymeren, wie zum Beispiel das in der Leiterplattentechnik eingesetzte Epoxidharz, durch deutlich bessere elektrische, mechanische beziehungsweise chemische Eigenschaften und haben im Falle der thermoplastischen Materialien den zusätzlichen Vorteil, durch die Technik des Spritzgusses in relativ einfacher Weise in beliebigen dreidimensionalen Formen herstellbar zu sein.

Diese Aufgabe wird gelöst durch ein Verfahren gemäß dem kennzeichnenden Teil des Patentanspruchs.

Vorteilhafte Ausführungen dieses Verfahrens sind in den Unteransprüchen beschrieben.

Das erfindungsgemäße Verfahren überwindet die Nachteile der bekannten Verfahren, beziehungsweise mildert diese deutlich ab, indem der naßchemische Arbeitsablauf bis zu ersten Metallisierung, in besonderen Ausführungsformen der vorliegenden Erfindung auch der gesamte oben genannte naßchemische Arbeitsablauf inklusive der ersten Metallisierung vermieden wird. Dies wird erfindungsgemäß dadurch erreicht, daß die Metallisierung der genannten Materialien durch Zersetzung metallorganischer Verbindungen in einem Plasma vorgenommen wird. Hierbei werden, je nach Behandlungszeit, Schichten von einigen Hundert bis etwa 2000 Å erhalten, die anschließend - ohne weitere Vorbehandlung - in einem chemischen Kupfer- oder Nickelbad in einem galvanischen Bad (meist Kupferbad) bis zur gewünschten Schichtstäörke verstärkt werden können.

Im Falle dickerer, nach dem erfindungsgemäßen Verfahren hergestellter, zusammenhängender Metallschichten kann es auch vorteilhaft sein, eine galvanische Metallisierung direkt anzuschließen.

Eine Erzeugung metallischer Strukturen kann hierbei nach einem der bekannten Verfahren (Additiv-, Semiadditiv-, Substraktivtechnik) erfolgen, zum Beispiel, indem die Substratoberfläche während der Plasma-Metallisierung durch eine Maske abgedeckt wird, so daß lediglich die Stellen freigelassen werden, die die metallischen Strukturen tragen sollen. Andere Ausführungsformen der Strukturierung, zum Beispiel mit Hilfe von Siebdrucklacken, Fotolacken oder Fotoresistfilmen sind in der Technik weit verbreitet und bekannt.

Selbstverständlich kann eine Strukturierung gemäß der Semiadditiv- oder Substraktivtechnik auch während des eventuell vorzunehmenden naßchemischen Metallisierungsprozesses durch Anwendung der in der Technik bekannten Verfahren erfolgen.

Die Metallisierung nach dem erfindungsgemäßen Verfahren erfolgt durch Zersetzung metallorganischer Verbindungen, vorzugsweise von Elementen der 1. und 8. Nebengruppe in Glimmentladungsplasmen. Es kommen aber auch andere metallorganische Verbindungen von Übergangsmetallen oder Hauptgruppenmetallen, (wie zum Beispiel Zinnverbindungen) zum Einsatz.

Es werden solche metallorganischen Verbindungen verwendet, die unzersetzt-eventuell unter Erwärmung - in die Gasphase überführt werden können, wie zum Beispiel $\pi$-Allyl$\pi$-Cyclopentadienyl-Palladium, Dimethyl-$\pi$-Cyclopentadienyl-Platin, Dimethyl-Gold-acetylacetonate und Kupfer-hexafluor-acetylacetonat.

Als besonders vorteilhaft hat sich die Kombination mehrerer Metalle herausgestellt, deren eines eine besonders gute Haftung zum Substrat und das andere zur nachfolgenden Metallschicht hat. Im Beispiel ist eine Anwendung beschrieben.

Die Plasmametallisierung im Sinne des kennzeichnenden Teils des Patentanspruchs wiest gegenüber den in der Technik bekannten Sputterverfahren den Vorteil auf, auch kompliziert geformte Teile metallisieren zu können. Es ist zum Beispiel möglich, in Spalten, Löchern (zum Beispiel Bohrungen in elektrischen Leiterplatten) oder im unmittelbaren Bereich von Hinterschneidungen eine Metallisierung zu erreichen.

Die Metallisierung erfolgt in normalen Plasmareaktoren, die hauptsächlich als Rohr- oder Tunnelreaktoen oder als Parallelplattenreaktoren und Reaktoren für Coronaentladungen bekannt sind. Für die Herstellung metallischer Filme und Strukturen kann das Plasma sowohl mit Gleichstrom als auch mit Wechselstrom oder Hochfrequenz (inklusive Mikrowellen), im allgemeinen im kHz- oder MHz-Bereich erzeugt werden. Der Druck in der Plasmakammer beträgt 0,1 - 2,0 hPa. Als Substrate kommen die eingangs erwähnten Fluorpolymere, wie zum Beispiel Polytetrafluoroethylen, und thermoplastische Kunststoffe, wie zum Beispiel Polyamide, Polyetherimide und -sulfone, Polyparaphenylensulfid, Polyester und parakristalline Polymere in den verschiedensten Ausführungsformen zum Einsatz: als Testmaterialien oder Folien, mit oder ohne Füllstoffe, einschichtig oder mehrschichtig.

Die für die Metallisierung nach erfindungsgemäßen Verfahren benutzten metallorganischen Verbindungen werden dem Plasmareaktor gasförmig zugeführt, vorzugsweise durch Sublimation oder Verdampfung. Sie können für sich allein benutzt werden, im allgemeinen verdünnt man sie aber mit Trägergasen, um gleichmäßige , porenfreie Schichten zu erhalten. Als Trägergase eignen sich inerte Gase, wie Argon und Helium oder reduzierende Gase wie Wasserstoff; auch Gemische können eingesetzt werden. Die Einspeisung der Organo-Metallverbindungen erfolgt nach Einstellung des Vakuums außerhalb der Glimmentladungszone in den Strom des Trägergases, so daß im eigentlichen Reaktionsbereich eine gleichmäßige Gasmischung vorliegt. Der Vorratsbehälter für die Metallverbindung wird zweckmäßigerweise mit einer Vorrichtung zum Heizen versehen, um schwerer sublimierbare Metallverbindungen in ausreichender Menge in den Gastrom zu führen.

Eine besondere Ausführungsform des erfindungsgemäßen Verfahrens besteht darin, daß vor dem Metallisierungsprozeß in der Plasmaentladung ein Plasma-Ätzprozeß vorgenommen wird, um die Substratoberfläche zu reinigen und für die Aufnahme der Metallschicht empfänglich zu machen. Die Ausführungsform des Reaktors und der Verfahrensbedingungen unterscheiden sich im Prinzip nicht von dem Plasma-Metallisierungsprozeß. Selbstverständlich werden jedoch beim Plasma-Ätzprozeß keine metallorganischen Verbindungen verwendet. Vorzugsweise werden dem inerten Trägergas reaktive Gase, wie zum Beispiel Sauerstoff oder Tetrafluormethan-Sauerstoff zugesetzt.

Eine alternative Verfahrensvariante besteht darin, den Ätzprozess und die Metallisierung im Plasma in einem Arbeitsgang vorzunehmen, indem zum Beispiel das Ätzgas unmittelbar nach dem Ätzprozess über das die metallorganische Verbindung enthaltende Vorratsgefäß geleitet wird, so daß die metallorganische Verbindung in die Reaktionszone gebracht wird und die Metallabscheidung eingeleitet wird. Im Beispiel ist diese Anwendung beschrieben.

Folgende Beispiele dienen der Erlauterung der Erfindung:

BEISPIEL 1

ABSCHEIDUNG VON KUPFER AUF POLYETHERIMID

| Reaktortyp: | Parallelplattenreaktor |
|---|---|
| Frequenz: | 13,56 MHz |
| Substrat: | Polyetherimidplättchen, ungefüllt (ULTEM$^R$ der Firma General Electric Plastics) |
| Substrattemperatur: | 293 K |
| 1. Vorbehandlung: | |
| Ätzgas: | O$_2$/Ar-Mischung 1 : 1 |
| Druck im Reaktor: | 8 Pa |
| Einwirkzeit: | 30 min |
| 2. Metallisierung: | |
| Metallorganische Verbindung: | Kupferhexafluoracetylacetonat |
| Temperatur des Reservoirs der metallorganischen | |
| Verbindung: | 338 K |
| Tragergas: | Wasserstoff |
| Druck im Reaktor: | 25 Pa |
| Einwirkzeit: | 10 min |

Ein Polyetherimidplättchen (70 x 40 x 4 mm) wird mit einer Maske aus nichtrostenden Stahl versehen, so daß die Bereiche auf den Plättchen freibleiben, die die Leiterbahnstrukturen tragen sollen. Anschließend wird das Plättchen auf die untere Platte des Reaktors gelegt, der Reaktionsraum wird evakuiert und das Plasma wird gezündet. Nach einer Vorbehandlung im O$_2$-Ar-Strom wird die Metallisierung gemäß oben angegebener Bedingungen durchgeführt. Man erhält einen Kupfer-Film von ca. 100 Å Dicke.

Die metallisierte Probe wird aus dem Reaktor herausgenommen, die Maske wird entfernt und die der Form der Maske entsprechenden Kupferstrukturen auf dem Plättchen werden in einem chemisch reduktiven Kupferbad verstärkt.

Derselbe Versuch kann auch mit Polyparaphenylensulfid (zum Beispiel RYTON R4® der Firma DuPont) oder dem parakristallinen Kunststoff VECTRA® (der Firma Celanese) durchgeführt werden. In diesem Fall werden die folgenden veränderten Vorbehandlungs- und Metallisierungsparameter gewählt.

BEISPIEL 2

Ein Teflonsubstrat wurde direkt (ohne Vorbehandlung einer Plasmametallisierung) unterworfen. Die Bedingungen sind wie folgt:

| Metallorganische Verbindung: | $\pi$-Allyl-$\pi$-cyclopentadienyl-Palladium |
|---|---|
| Trägergas: | Argon, 100 sccm * |
| Druck im Reaktor: | 9 Pa |
| Leistungsdichte: | 0.44 Watt/cm$^2$ |
| Expositionszeit: | 5 min |

* Standard - cm$^3$

Nach der Plasmametallisierung erfolgt eine stromlose und galvanische Metallisierung zur Ermittlung der Haftfestigkeit. Sie beträgt nur 0.3 - 0.4 N/mm.

Man erhält einen ca. 100 Å dicken Palladiumfilm. Das metallisierte Substrat wird anschließend ohne weitere Vorbehandlung in einem stromlosen Kupferbad verkupfert, so daß eine dichte und lückenlose Metallschicht entsteht. Zur Bestimmung der Haftung wird mit einem galvanischen Kupferelektrolyten auf ca.

30 m verstärkt. Nach einer Temperung bei 50 - 70° C erhält man Haftfestigkeiten von 2-3 N/mm. Die beim Schältest abgezogene Kupferfolie weist auf der Rückseite festhaftendes Substratmaterial auf, da ein Bruch innerhalb des Verbundsystems Teflon/Glasfasergewebe erfolgt.

## BEISPIEL 3

### ABSCHEIDUNG VON GOLD AUF POLYTETRAFLUORETHYLEN

| | |
|---|---|
| Reaktortyp:<br>Frequenz:<br>Substrat:<br>Substrattemperatur | Parallelplattenreaktor<br>13,56 MHz<br>Polytetrafluorethylen-Folie (0,5 mm Starke) |
| 1. Vorbehandlung: | |
| Ätzgas:<br>Druck im Reaktor:<br>Einwirkzeit: | Tetrafluormethan/Sauerstoffgemisch = 1/3,5<br>8 Pa<br>30 min |
| 2. Metallisierung | |
| Metallorganische Verbindung: | Dimethyl-Gold-Acetonyl-acetat |
| Temperatur des Reservoirs der metallorganischen | |
| Verbindung:<br>Tragergas:<br>Druck im Reaktor:<br>Einwirkzeit: | Au: 313 K<br>Argon<br>10 Pa<br>10 min |

Die Polytetrafluorethylen Folien werden wie im Beispiel 1 beschrieben, mit einer Metallmaske versehen. Im ersten Fall werden die Folien unter den oben angegebenen Bedingungen ohne Vorbehandlung metallisiert. Die Proben werden in einem chemisch reduktiven Kupferbad auf ca. 4 μm verstärkt und anschließend über den Galvanorand, der zusammenhängende Metallstrukturen ermöglicht, in einem galvanischen Kupferbad auf ca. 20 μm verstärkt.

Nach einer Temperung der Proben für 24 Stunden bei 50° C wird mit dem Schältest eine Haftung von ca. 0,5 Newton/mm gemessen.

Nimmt man vor der Metallisierung eine Vorbehandlung im Plasma unter den oben angegebenen Bedingungen vor, so werden nach der Temperung Haftungswerte von ca. 3 - 3,5 Newton/mm gemessen.

## BEISPIEL 4

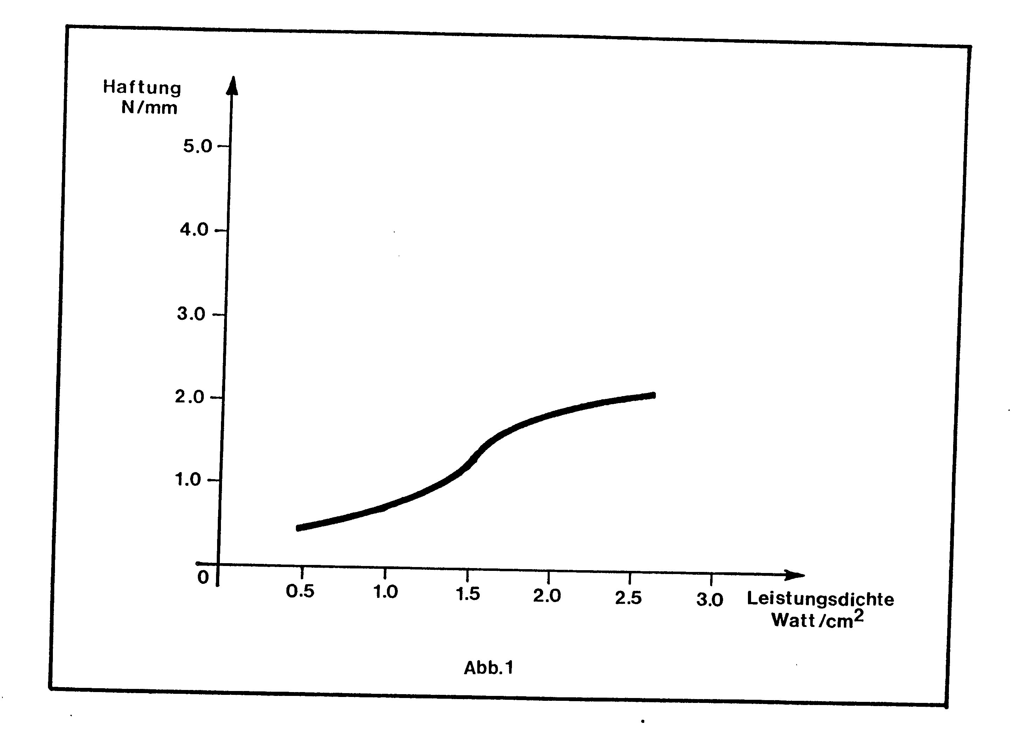

Das Teflonsubstrat wird bei verschiedenen Leistungsdichten des Plasmas vorbehandelt. Die Versuchsparameter der Plasmavorbehandlung und -metallisierung, stromlosen und galvanischen Verkupferung sind wie in Beispiel 3. Die gemessenen Haftfestigkeiten sind in Abb. 1 angegeben.

## BEISPIEL 5

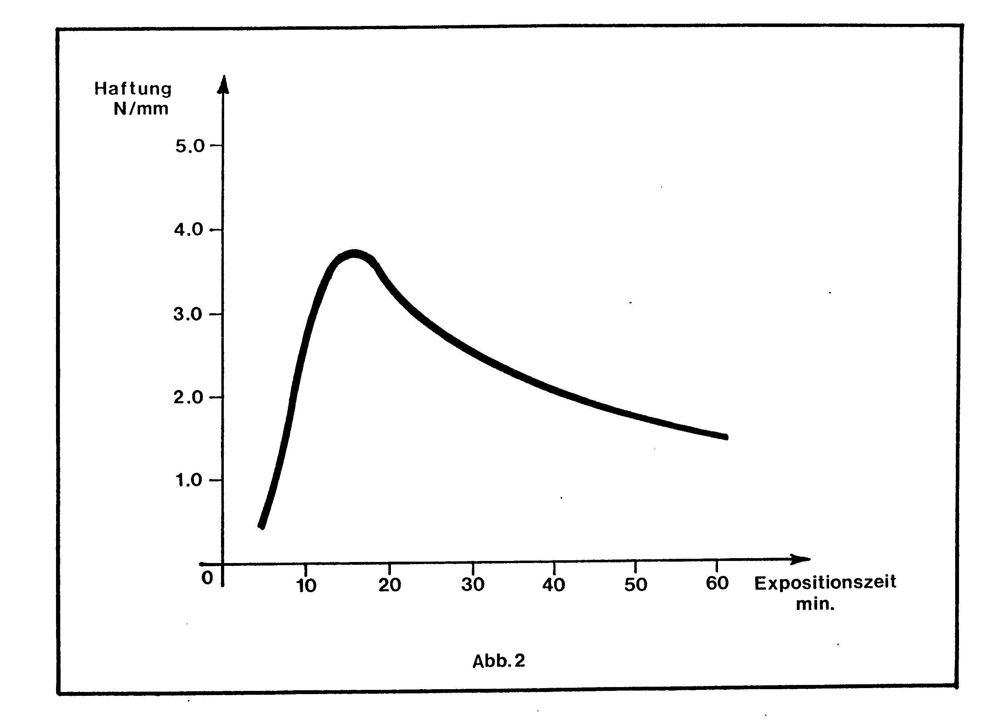

Wie Beispiel 3, jedoch Variation der Dauer der Plasmavorbehandlung. Die Ergebnisse sind in Abb. 2 angegeben.

## BEISPIEL 6

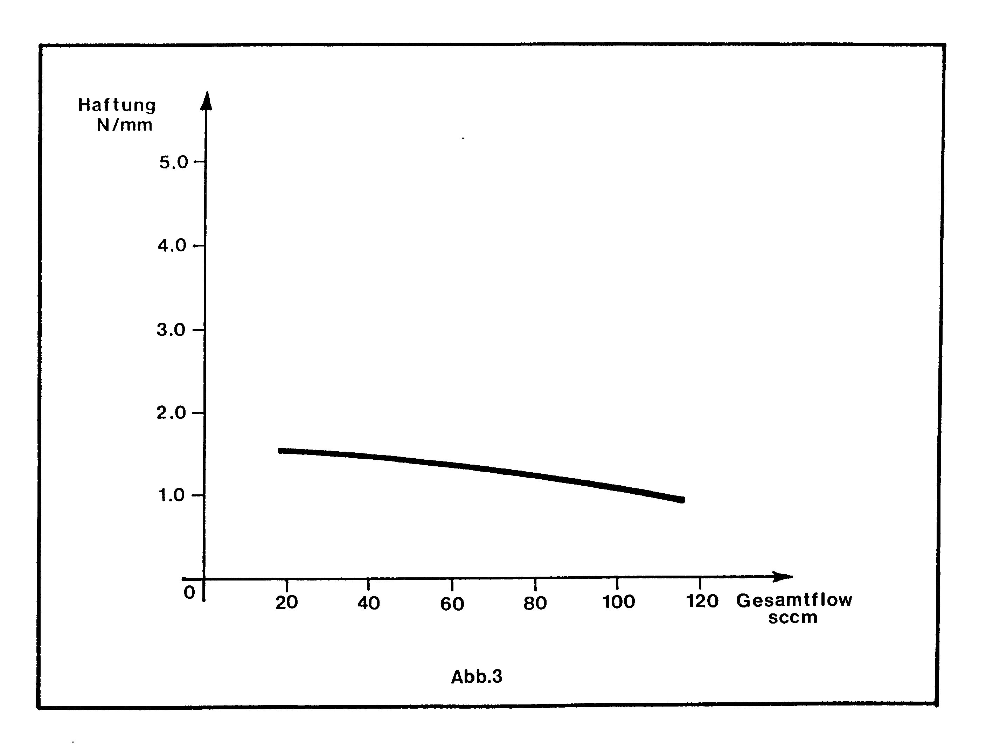

Wie Beispiel 3, jedoch Variation der Durchflußrate des CF₄/O₂-Gasgemisches bei der Plasmavorbehandlung (7/4V/V). Die Ergebnisse sind in Abb. 3 wiedergegeben.

BEISPIEL 7

Wie Beispiel 3 jedoch Variation der Durchflußrate der Ar bei der Metallisierung. Es wurde keine Abhängigkeit gefunden. Die Haftfestigkeiten liegen zwischen 1.5 und 1.7 N/mm.

BEISPIEL 8

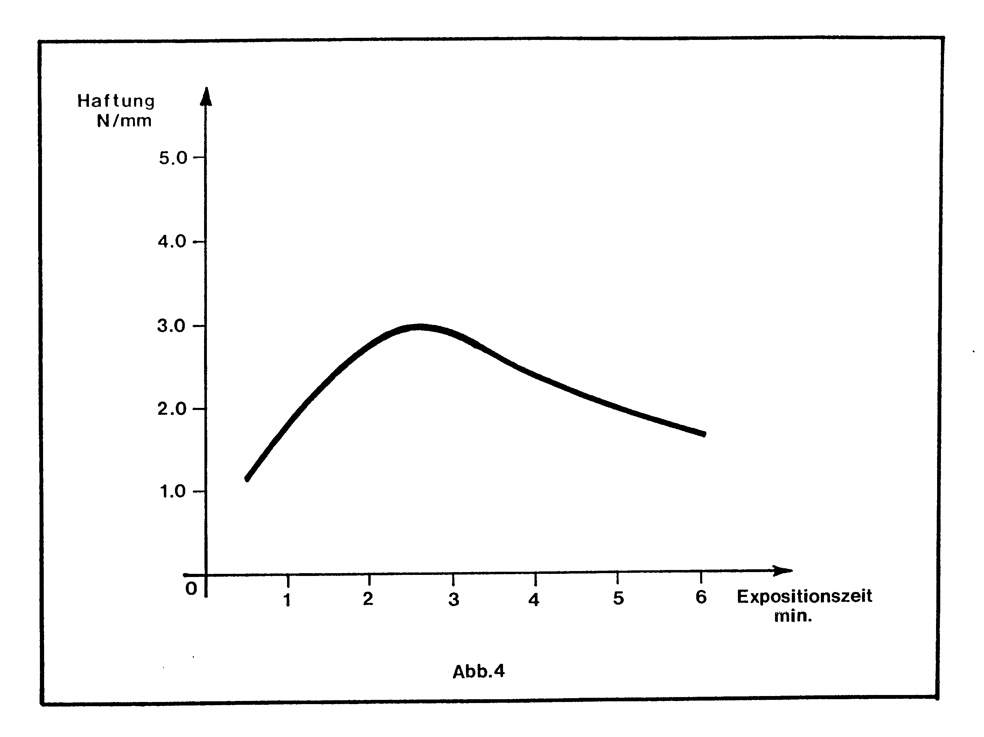

Wie Beispiel 3, jedoch Variation der Expositionszeit bei der Metallisierung. Die Ergebnisse sind in Abb. 4 gezeigt. Daraus ist zu entnehmen, daß eine kurze Metallisierung-(Bekeimungs-)zeit zum Erreichen einer maximalen Haftfestigkeit vorteilhaft ist. Bei Verlängerung der Expositionszeit verringert sich die Haftfestigkeit des Metallüberzuges wieder.

BEISPIEL 9

Die Haftfestigkeit von Kupferfilmen auf vorher in Plasma vorbehandelten und mit verschiedenen Metallen im Plasma bekeimten Teflon/Glasfasersubstraten wurde gemessen. Die experimentellen Bedingungen waren wie folgt:

| Vorbehandlung: | 1.32 Watt/cm$^2$ |
| | 10 min Expositionszeit |
| Metallisierung: | 100 sccm Ar |
| | 0.44 Watt/cm$^2$ |
| | 5 min Expositionszeit |

Die Ergebnisse sind in Tab. 1 wiedergegeben.

TABELLE 1

| Metallverbindung | Haftfestigkeit/Nmm$^{-1}$ |
|---|---|
| Gaszusammensetzung: 20 sccm $O_2$, 35 sccm $CF_4$: | |
| $\pi$-Allyl-$\pi$-cyclopentadienyl-Palladium | 3.0 - 5.0 |
| Dimethyl-Gold-acetonyl-acetat | 2.5 - 3.5 |
| Gaszusammensetzung: 35 sccm $O_2$, 35 sccm Ar: | |
| $\pi$-Allyl-$\pi$-cyclopentadienyl-Palladium (A) | 1.5 - 2.0 |
| $\pi$-Allyl-$\pi$-cyclopentadienyl-Platin (B) | $\approx$ 1.5 |
| Dimethyl-Gold-acetonylacetat | $\approx$ 1.5 |
| Kupferhexafluoroacetonylacetat[*) | $\approx$ 2.5 |
| Mischung aus A und B | 3.0 - 3.5 |
| *) Trägergas: 300 sccm $H_2$ | |

BEISPIEL 10

Unter den im Beispiel 9 angegebenen Bedingungen (mit Pd-Metallisierung) wurde die Zusammensetzung der Vorbehandlungsgasmischung variiert. Die Gesamtdurchflußrate der Gasmischung wurde bei 70 sccm konstant eingestellt.
Die Ergebnisse sind in Tab. 2 wiedergegeben.

TABELLE 2

| Gaszusammensetzung | Haftfestigkeit/$Nmm^{-1}$ | rel Ätzraten [*] / % |
|---|---|---|
| 50 % $O_2$, 50 % Ar | 2.0 - 3.75 | - |
| 50 % $O_2$, 22 % Ar, 28 % $CF_4$ | 1.5 - 2.5 | - |
| 50 % $O_2$, 50 % $CF_4$ | $\approx 1.0$ | 100 |
| 28 % $O_2$, 72 % $CF_4$ | 3.0 - 5.0 | 95 |
| 72 % $O_2$, 28 % $CF_4$ | 1.9 - 3.0 | 104 |
| 100% $CF_4$ | 1.0 - 1.5 | 100 |

[*] Plasmavorbehandlung (Referenz 100% $CF_4 \triangleq 100\%$)

## BEISPIELE 11-16

Die Metallisierungsversuche wurden an verschiedenen Kunststoffen durchgeführt. Die Reaktionsbedingungen waren wie in Beispiele 3 angegeben. Die Versuchsergebnisse sind in Tabelle 3 aufgezeigt. In jedem Falle wurden nach dem Schältest Kunststoffreste an der Rückseite des abgezogenen Kupferstreifens gefunden.

TABELLE 3

| Kunststoff | Haftfestigkeit / $Nmm^{-1}$ |
|---|---|
| 1. Acrylnitril-butadien-styrol-copoplymer | 0.8 - 1.1 |
| 2. Acrylnitril-butadien-styrol-copolymer | 1.5 - 1.6 |
| 3. Polycarbonat-polyester-copolymer | 1.1 - 1.3 |
| 4. Polyphenylenoxid | 1.0 - 1.2 |
| 5. Polyamid | $\approx 2.0$ |
| 6. Polyamid | 1.1 - 1.3 |

## BEISPIEL 17

Ein Teflon/Glasfasersubstrat wurde wie in Beiepiel 3 im Plasma vorbehandelt und metallisiert. Abnschließend wurde direkt 1,5 h lang in einem handelsüblichen stromlosen Nickelbad metallisiert. Man erhält eine ca. 30 $\mu$m dicke Nickelschicht.
Die gemssene Haftfestigkeit beträgt wie bei einer stromlosen und galvanischen Verkupferung 2-3 N/mm.

## BEISPIEL 18

Ein gebohrtes Teflon/Glasfasersubstrat (1.3 mm Löcher) wurde im Plasma vorbehandelt und metallisiert (experimentelle Bedingungen wie in Beispiel 3). Anschließend erfolgt eine stromlose Verkupferung. Die erzielte Kupferschichtdicke beträgt 0.2 - 0.3 $\mu$m. Zur Prüfung der Metallbelegung an der Bohrlochwand wird das Bohrloch längs aufgeschnitten und von der Rückseite durch das Substratmaterial hindurch mit einer kräftigen Lichtquelle beleuchtet (Durchlichttest). Unter dem Mikroskop sind keine hellen Stellen feststellbar, die auf mangelnde Metallbelegung auf der Bohrlochinnenseite hinweisen.

BEISPIEL 19

Ein Teflonsubstrat wird ganzflächig nach dem in Beispiel 3 angegebenen Verfahren in Plasma vorbehandelt, metallisiert und anschließend naßchemisch verkupfert. Die allseitig metallisierte Teflonplatte wird einem thermischen Schock in einem Lötbad (10 s tauchend bei 288° C) behandelt. Es bilden sich keine Blasen in der Kupferschicht. Die Haftfestigkeit der Metallauflage wird durch die thermische Behandlung nicht beeinträchtigt.


BEISPIEL 20

Ein Teflon/Glasfasersubstrat wird in folgender Weise im Plasma vorbehandelt und metallisiert:
Nach Erreichen des Vakuums wird in bekannter Weise mit einer $CF_4/ O_2$ - Gasmischung (7/4 V/V) vorbehandelt. Nach 10 min wird die Gasmischung über das die metallorganische Verbindung (zum Beispiel $\pi$-Allyl-$\pi$-Cyclopentadienyl-Palladium) enthaltende Vorratsgefäß geleitet und damit zusätzlich die Metallverbindung in die Plasmakammer gebracht. Dadurch wird die Metallabscheidung in Gang gesetzt. Nach 5 min Expositionszeit wird die Metallabscheidung abgebrochen. Die Proben werden wie in Beispiel 3 verkupfert. Es bildet sich bereits nach der stromlosen Verkupferung eine dichte Metallschicht. Die technischen Eigenschaften des mit ca. 30 μm metallisierten Substrats (wie Haftfestigkeit, Lötbeständigkeit) entsprechen den in den vorangegangenen Beispielen beschriebenen Systemen.


**Ansprüche**

1. Verfahren zur Herstellung metallischer Strukturen auf Nichtleitern durch Zersetzung metallorganischer Verbindungen in einer Glimmentladung unter Bildung eines metallischen Films, dadurch gekennzeichnet, daß als Nichtleiter Kunststoffe aus dem Bereich der Fluorpolymere oder der thermoplastischen Kunststoffe verwendet werden.

2. Verfahren nach Anspruch 1, dadurch gekennzeichnet, daß die Oberfläche der Nichtleiter vor dem Metallisierungsprozeß einem Ätz- und Reinigungsprozeß in einer Glimmentladung unterworfen wird.

3. Verfahren nach den Anspruch 1, dadurch gekennzeichnet, daß der in der Glimmentladung bei der Metallisierung erhaltene Film in einem Bad zur chemisch reduktiven Metallabscheidung ,vorzugsweise einem chemisch reduktiven Kupferbad oder einem chemisch reduktiven Nickelbad ,verstärkt wird.

4. Verfahren nach Anspruch 1, dadurch gekennzeichnet, daß die Strukturen durch Auflegen von Masken oder durch Auftragen von Siebdrucklacken oder Fotolacken vorgegeben werden.

5. Verfahren nach Anspruch 1, dadurch gekennzeichnet, daß die Strukturen nach der Metallisierung mit Hilfe von Fotoresist, Fotolacken oder Siebdrucklacken erzeugt werden.

6. Verfahren nach Anspruch 1, dadurch gekennzeichnet, daß zur Abscheidung des metallischen Films organische Kupferverbindungen verwendet werden.

7. Verfahren nach Anspruch 1, dadurch gekennzeichnet, daß zur Abscheidung des metallischen Films organische Palladiumverbindungen verwendet werden.

8. Verfahren nach Anspruch 1, dadurch gekennzeichnet, daß zur Abscheidung des metallischen Films organische Platinverbindungen verwendet werden.

9. Verfahren nach Anspruch 1, dadurch gekennzeichnet, daß zur Abscheidung des metallischen Films organische Goldverbindungen verwendet werden.

10. Verfahren nach Anspruch 1, dadurch gekennzeichnet, daß zur Abscheidung des metallischen Films ein Gemisch organischer Palladium- und Platinverbindungen verwendet wird.

Abb.1

EP 0 321 734 A1

Abb. 2

EP 0 321 734 A1

Abb.3

Abb.4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 195 223 (SCHERING AG) <br> * Seite 5, Beispiel 3; Ansprüche 1-9 * <br> --- | 1-7 | C 23 C 16/18 <br> C 23 C 16/16 <br> H 05 K 3/02 |
| X | EP-A-0 027 625 (RUHRCHEMIE AG) <br> * Seite 3, Zeilen 1-6; Seite 6, Zeilen 3-4; Seite 11, Beispiele 5,7 * <br> --- | 1,6 | |
| X | JOURNAL OF VACUUM SCIENCE & TECHNOLOGY A, Band 3, Nr. 6, November-Dezember 1985, "Second Series", Seiten 2093-2097, New York, N.Y., US; R.K. SADHIR et al.: "Deposition of conducting thin films of organometallic monomers by plasma polymerization" <br> * Seite 2094, Absatz B * <br> --- | 1 | |
| A | US-A-3 294 059 (C.R. BARNES et al.) <br> * Spalte 1, Zeilen 15-21; Anspruch 1 * <br> --- | 1 | |
| A | US-A-4 568 413 (J.J. TOTH et al.) <br> * Spalte 5, Zeilen 35-37; Spalte 5, Zeilen 49-53; Anspruch 4 * <br> --- | 1,9 | **RECHERCHIERTE SACHGEBIETE (Int. Cl.4)** |
| E | EP-A-0 291 444 (SCHERING AG) <br> * Seite 5, Beispiel 3; Anspruch 1 * <br> ----- | 1,9 | C 23 C <br> H 05 K |

Der vorliegende Recherchenbericht wurde für alle Patentansprüche erstellt

| Recherchenort | Abschlußdatum der Recherche | Prüfer |
|---|---|---|
| DEN HAAG | 30-03-1989 | JOFFREAU P.O. |